(19) Europäisches Patentamt

European Patent Office

Office européen des brevets

(11) **EP 3 252 830 B1**

(12) **FASCICULE DE BREVET EUROPEEN**

(45) Date de publication et mention
de la délivrance du brevet:
**02.01.2019 Bulletin 2019/01**

(21) Numéro de dépôt: **17173571.5**

(22) Date de dépôt: **30.05.2017**

(51) Int Cl.:
*H01L 31/0236* (2006.01)    *B82Y 40/00* (2011.01)
*H01L 21/265* (2006.01)    *H01L 21/266* (2006.01)
*H01L 33/00* (2010.01)    *H01J 37/317* (2006.01)
*H01L 21/3065* (2006.01)    *H01L 21/308* (2006.01)
*H01L 31/18* (2006.01)    *H01L 21/306* (2006.01)

(54) **PROCÉDÉ DE RÉALISATION DE MOTIFS PAR IMPLANTATIONS IONIQUES**

VERFAHREN ZUR HERSTELLUNG VON MUSTERN UNTER VERWENDUNG VON IONENIMPLANTATIONEN

METHOD FOR FORMING PATTERNS BY IONS IMPLANTATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.06.2016 FR 1655090**

(43) Date de publication de la demande:
**06.12.2017 Bulletin 2017/49**

(73) Titulaire: **Commissariat à l'Energie Atomique et aux Energies Alternatives**
**75015 Paris (FR)**

(72) Inventeurs:
• **LANDIS, Stefan**
**38210 Tullins (FR)**
• **BARNOLA, Sébastien**
**38190 Villard-Bonnot (FR)**
• **DAVID, Thibaut**
**38570 Goncelin (FR)**
• **NOURI, Lamia**
**94270 Le Kremelin Bicêtre (FR)**
• **POSSEME, Nicolas**
**38360 Sassenage (FR)**

(74) Mandataire: **Hautier, Nicolas**
**Cabinet Hautier**
**20, rue de la Liberté**
**06000 Nice (FR)**

(56) Documents cités:
**US-A1- 2015 214 099    US-B2- 6 365 525**

• **KIM SANG WAN ET AL: "Enhanced patterning by tilted ion implantation", SPIE - INTERNATIONAL SOCIETY FOR OPTICAL ENGINEERING. PROCEEDINGS, S P I E - INTERNATIONAL SOCIETY FOR OPTICAL ENGINEERING, US, vol. 9777, 22 mars 2016 (2016-03-22), pages 97771B-97771B, XP060067773, ISSN: 0277-786X, DOI: 10.1117/12.2218793 ISBN: 978-1-5106-0753-8**

**Description**

DOMAINE TECHNIQUE DE L'INVENTION

La présente invention concerne un procédé de structuration de la surface d'un substrat et plus généralement un procédé de réalisation de motifs à la surface d'un substrat.

L'invention trouve pour applications avantageuses mais non limitatives la microélectronique, l'optique ou encore l'optronique.

ÉTAT DE LA TECHNIQUE

La possibilité d'obtenir des tranches ou plaques (« wafers ») et des substrats, à surface structurée (« patterned substrate ») c'est-à-dire dont la surface est au moins en partie couverte de motifs en relief, peut s'avérer très avantageuse. C'est en particulier le cas pour la plupart des dispositifs de type optiques ou optoélectronique et notamment les diodes électroluminescentes (DEL) dont l'efficacité de conversion d'un courant électrique en lumière est très dépendante de l'état de surface du substrat à partir duquel on les fabrique.

Les procédés existants pour structurer des substrats comprennent de nombreuses étapes de lithographie, combinant par exemple impression nanométrique et étapes de photolithographie. Par ailleurs, le document US 2015/214099 A1 décrit un procédé de formation d'un relief à la surface d'un substrat, procédé dans lequel deux implantations d'ions, dans des directions différentes, sont réalisées dans le substrat, et une gravure des zones implantées est ensuite mise en oeuvre.

Ces procédés existants ne permettent d'obtenir que des formes relativement simples et avec peu de liberté sur les motifs obtenus, sauf à accroitre considérablement la complexité et donc le coût de ces procédés.

Il existe donc un besoin consistant à proposer une solution pour obtenir de manière reproductible et peu onéreuse de motifs possiblement complexes à la surface d'un substrat.

Un objet de l'invention consiste à proposer une telle solution.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Pour atteindre cet objectif, selon un mode de réalisation la présente invention prévoit un procédé de formation de reliefs à la surface d'un substrat, caractérisé en ce qu'il comprend au moins les étapes suivantes:

- au moins une première implantation d'ions dans le substrat selon une première direction ;

- au moins une deuxième implantation d'ions dans le substrat selon une deuxième direction différente de la première direction;
- au moins l'une des première et deuxième implantations est réalisée à travers au moins un masque présentant au moins un motif;
- une gravure de zones du substrat ayant reçu par implantation une dose supérieure ou égale à un seuil, sélectivement aux zones du substrat n'ayant pas reçu par implantation une dose supérieure audit seuil.

Les paramètres des première et deuxième implantations, en particulier leurs directions respectives, étant réglées de manière à ce qu'uniquement des zones du substrat ayant été implantées à la fois lors de la première implantation et lors de la deuxième implantation reçoivent une dose supérieure ou égale audit seuil.

Ainsi, le procédé selon la présente invention permet d'obtenir de manière particulièrement simple des motifs possiblement complexes.

Par exemple on peut obtenir des motifs en trois dimensions ou des motifs analogiques, c'est-à-dire des motifs présentant un profil continu ou des motifs avec plusieurs niveaux de hauteur ou de profondeur. La plupart des procédés existants, sauf à être très complexes, ne permettent que d'obtenir des motifs binaires, c'est dire avec un seul niveau de hauteur ou de profondeur.

Par ailleurs ce procédé permet de définir les motifs souhaités avec une grande liberté de choix. En outre ce procédé permet de contrôler simplement et de façon très reproductible les caractéristiques géométriques des motifs du substrat.

Le procédé selon l'invention s'est avéré particulièrement avantageux pour réaliser des réseaux de diffraction ou des réseaux d'absorption, par exemple pour le marché des LED ou du photovoltaïque.

En particulier le procédé selon l'invention permet de réaliser de façon très reproductible des motifs de petites tailles à la surface des substrats à partir desquels les DELs sont fabriquées.

De manière facultative, le procédé selon l'invention peut présenter au moins l'une quelconque des caractéristiques optionnelles suivantes :

- Selon un mode de réalisation, les première et deuxième implantations sont chacune réalisées à travers au moins un masque. Selon un mode de réalisation, l'au moins un motif du masque utilisé lors de la première implantation est différent de l'au moins un motif du masque utilisé lors de la deuxième implantation.

Selon un mode de réalisation, les première et deuxième implantations sont réalisées à travers un même masque, le procédé comprenant au moins une implantation additionnelle réalisée à travers un masque différent de celui utilisé lors des première et deuxième implantations.

Alternativement au moins l'une des première et deuxième implantations est réalisée pleine plaque et sans masque.

- Selon un mode de réalisation, on dispose une couche sacrificielle au-dessus du substrat et au moins l'une parmi la première et la deuxième implantations est réalisée à travers ladite couche sacrificielle.
- Selon un mode de réalisation, on retire toute la couche sacrificielle après la deuxième implantation.
- Selon un mode de réalisation, la couche sacrificielle est un revêtement anti-réflexion (BARC).
- Selon un mode de réalisation, l'épaisseur de la couche sacrificielle est choisie et au moins l'une parmi la première et la deuxième implantations sont réalisées de manière à ce que des premières zones situées sous le masque soient implantées à la fois lors de la première implantation et lors de la deuxième implantation, reçoivent une dose supérieure ou égale audit seuil et s'étendent uniquement dans la couche sacrificielle.

Ainsi ces premières régions ne s'étendent pas dans le substrat. Les motifs de ces régions ne seront ainsi pas gravés dans le substrat.
Cela permet de lisser le profil obtenu sans avoir à effectuer une opération d'amincissement, tel qu'un polissage mécano-chimique pour éliminer les reliefs les moins profonds.

- Selon un mode de réalisation, l'épaisseur de la couche sacrificielle ainsi qu'au moins l'une parmi la première et la deuxième implantations sont réalisées de manière à ce que des deuxièmes zones situées sous le masque soient implantées à la fois lors de la première implantation et lors de la deuxième implantation en recevant une dose supérieure ou égale audit seuil, lesdites deuxièmes régions s'étendant dans la couche sacrificielle et dans le substrat.

Ainsi ces deuxièmes régions s'étendent dans le substrat.

- Selon un mode de réalisation, le substrat est cristallin et au moins l'une des première et deuxième implantations est effectuée de manière à modifier la structure physique du substrat pour le rendre amorphe. Selon un mode de réalisation, cette implantation comprend l'implantation des ions plus lourds que l'hydrogène (H), tels que des ions argon (Ar), silicium (Si) ou encore Bore (B), avec une énergie suffisante pour rendre les zones implantées amorphes. Par exemple, afin d'effectuer une modification physique du substrat, on pourra utiliser des ions dont la masse atomique est supérieure ou égale à celle du Bore.
- Selon un mode de réalisation, au moins l'une parmi la première et la deuxième implantations est effectuée de manière à modifier chimiquement le substrat. Selon un mode de réalisation, cette implantation effectuée de manière à modifier chimiquement le substrat comprend l'implantation d'ions hydrogène (H) et/ou d'oxygène pour modifier chimiquement le substrat.

- Selon un mode de réalisation, ladite implantation effectuée de manière à rendre les zones implantées amorphes est la première implantation et dans laquelle ladite implantation effectuée de manière à modifier chimiquement le substrat est la deuxième implantation.
- Selon un mode de réalisation alternatif, ladite implantation effectuée de manière à modifier chimiquement le substrat est la première implantation et dans laquelle ladite implantation effectuée de manière à rendre les zones implantées amorphes est la deuxième implantation.
- Selon un mode de réalisation, au moins certaines des zones recevant une dose supérieure ou égale audit seuil sont situées sous un motif du masque lors d'au moins l'une des première et deuxième implantations.
- Selon un mode de réalisation, au moins l'une des première et deuxième directions d'implantation est perpendiculaire à un plan principal dans lequel s'étend le substrat.
- Selon un mode de réalisation, à la fois la première et la deuxième direction d'implantation sont inclinées par rapport à une direction perpendiculaire à un plan principal dans lequel s'étend le substrat.
- Selon un mode de réalisation, le substrat est fait d'un matériau pris parmi l'un des matériaux suivants : silicium (Si), en silicium-germanium (SiGe), saphir, GaN, le SiC, et le quartz.
- Selon un mode de réalisation, le substrat est poreux.
- Selon un mode de réalisation, les paramètres des première et deuxième implantations, en particulier leurs directions respectives, sont réglées de manière à ce que certaines zones du substrat ne reçoivent aucune dose lors d'au moins l'une parmi la première et la deuxième implantations.

Ainsi en inclinant suffisamment l'une des implantations, les motifs du masque empêchent aux ions de pénétrer dans le substrat en certaines zones.
Ainsi, en certaines zones, le substrat conserve son intégrité alors que dans d'autres de ses zones il est modifié et éventuellement gravé.

- Selon un mode de réalisation, les paramètres des première et deuxième implantations, en particulier leurs directions et leur énergie, sont réglées de manière à ce que durant l'une seulement parmi la première et la deuxième implantations, des ions pénètrent dans le substrat sans traverser le masque.

L'invention décrit ainsi un procédé de structuration tridimensionnelle de la surface du substrat comprenant une étape initiale où l'on forme à la surface dudit substrat un masque de motifs bidimensionnels, et dans lequel on implante à travers le masque de motifs 2D la surface dudit substrat à l'aide d'un faisceau d'ions, le faisceau d'ions incliné. On obtient ainsi à la surface du substrat une implantation 3D en raison de l'écran formé par le masque de motifs 2D traversé par le faisceau avec une inclinaison différente de la normale.

Un autre objet de la présente invention concerne un dispositif microélectronique comprenant un substrat présentant une surface portant des motifs obtenus selon le procédé de l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

> La FIGURE 1, composée des figures 1a à 1e, illustre un premier mode de réalisation pour obtenir une surface structurée selon un exemple de procédé de l'invention à l'aide d'une implantation d'espèces à travers un masque.
> La FIGURE 2, composée des figures 2a à 2c, illustre un deuxième mode de mise en oeuvre de l'invention où l'on répète les étapes précédentes avec un second masque.
> La FIGURE 3, composée des figures 3a à 3c, illustre encore un autre mode de réalisation pour obtenir une structuration de surface d'un substrat, en utilisant une couche sacrificielle.
> La FIGURE 4, composée des figures 4a à 4b, étudie la pénétration des ions dans des motifs en résine du masque.
> La FIGURE 5, composée des figures 5a à 5f, illustre et discute différentes options de réglage de l'angle d'incidence du faisceau d'ions sur le résultat de l'implantation d'espèces pour la structuration de surface d'un substrat.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives du substrat, du masque et de ses motifs ne sont pas représentatives de la réalité.

DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans le cadre de la présente invention, on qualifie de résine un matériau organique ou organo-minéral pouvant être mis en forme par une exposition à un faisceau d'électrons, de photons ou de rayons X ou mécaniquement.

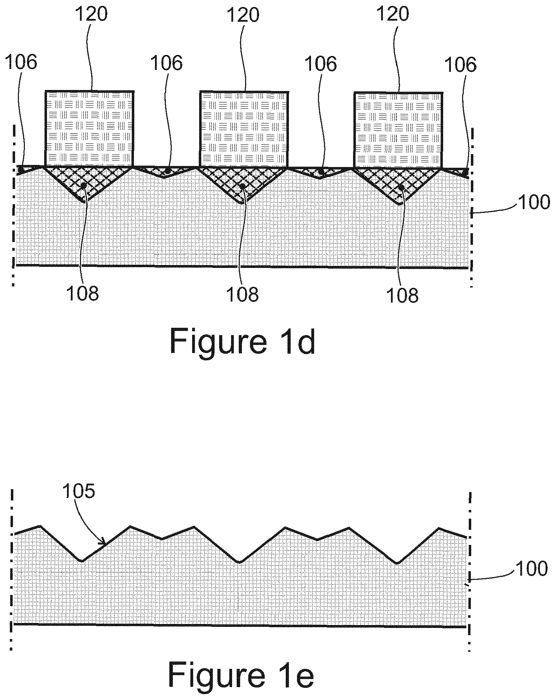

Dans le cadre de la présente invention, on désigne par motif en trois dimensions un motif présentant dans le substrat, au moins deux niveaux de profondeur au-dessous de la face supérieure du substrat lorsque le motif est en creux ou au moins deux niveaux de hauteur au-dessus d'une face supérieure du substrat lorsque le motif est en saillie. Cela apparaît clairement sur la figure 1e par exemple qui sera décrite en détail par la suite.

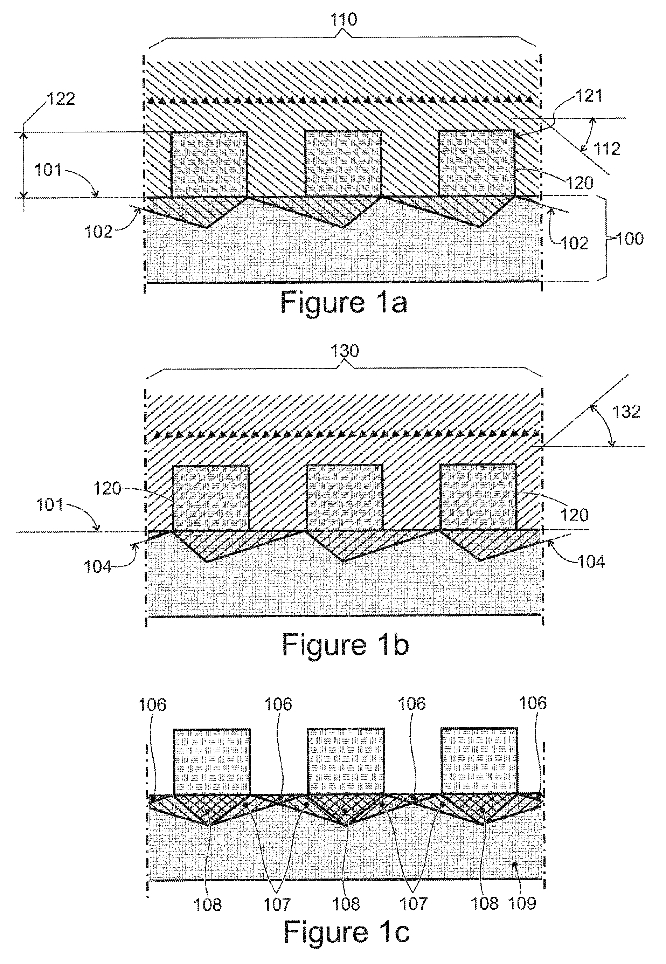

Dans la présente demande de brevet, l'épaisseur est prise selon une direction perpendiculaire à la face 101 principale du substrat 100 à graver. Sur les figures 1 à 3, l'épaisseur est prise selon la verticale.

De même lorsqu'on indique qu'un élément est situé au droit d'un autre élément, cela signifie que ces deux éléments sont situés tous deux sur une même ligne perpendiculaire au plan principal du substrat 100, soit sur une même ligne orientée verticalement sur les figures

La **figure 1**, composée des figures 1a à 1e, illustre une première façon d'obtenir une surface structurée selon le procédé de l'invention.

Ce procédé est effectué à partir d'un empilement comprenant au moins un substrat 100 surmonté d'un masque 121. Le substrat 100 peut également être qualifié de couche à graver.

Le substrat 100 peut être autoportant ou non. Il peut reposer ou non sur une ou plusieurs autre(s) couche(s). Le substrat 100 peut être monocristallin, polycristallin ou amorphe selon les applications considérées. Le substrat est typiquement fait d'un matériau comprenant au moins l'un des matériaux suivants : silicium (Si), silicium-germanium (SiGe) saphir, SiN, GaN, SiC, et quartz. Par exemple le substrat 100 peut être en silicium (Si), en silicium-germanium (SiGe) de préférence monocristallin ou polycristallin. Le substrat 100 peut également être en quartz, ou en saphir.

Le substrat 100 peut être poreux. Dans le cadre de la présente invention, on désigne par substrat poreux, un substrat dont la présence de vide est supérieure à 5% en volume et de préférence comprise entre 5 et 10%. Il peut par exemple s'agir de SiOCH poreux.

Comme montré sur la figure 1a on procède tout d'abord à une première implantation d'espèces à travers la surface 101 du substrat 100. L'implantation, sous la forme d'un faisceau d'ions 110, se fait de façon conventionnelle en mettant en oeuvre des techniques et moyens classiques et en particulier en utilisant les implanteurs et graveurs plasma.

Selon ce mode de réalisation illustré en figure 1, le faisceau d'ions n'est pas dirigé perpendiculairement au plan défini par la surface 101 du substrat mais est appliqué avec une inclinaison 112, aussi noté $\alpha$, par rapport à ce plan.

Cette implantation est réalisée à travers un masque 121 portant des motifs 120. Selon un exemple non limitatif, ces motifs 120 sont réalisés à partir d'une couche de résine photosensible ou thermosensible en mettant en oeuvre l'une ou l'autre des techniques conventionnelles de photolithographie ou d'impression nanométrique développées depuis des décennies par l'industrie de la microélectronique ou en les combinant.

Selon un mode de réalisation alternatif, le masque est un masque dur. Il peut alors être réalisé selon les étapes suivantes : dépôt du matériau formant le masque, (par exemple SiN ou SiO2...) ; puis dépôt d'une couche de résine et formation des motifs par lithographie dans la résine; puis ouverture du masque ; puis retrait de la résine.

Dans l'implanteur ou graveur plasma utilisé, on communique au faisceau d'ions 110 suffisamment d'énergie pour que la trajectoire de ceux-ci ne soit pas sensiblement déviée par les motifs 120. Ces derniers constituent cependant un obstacle qui fait partiellement écran à la propagation du faisceau d'ions et permet ainsi d'obtenir une implantation à des profondeurs variables à partir de la surface du substrat 101. L'implantation des ions à l'issue de cette première implantation définit ainsi le profil 102 illustré en figure 1a. Comme on le verra par la suite, d'une façon générale, la forme et l'espacement des motifs sont adaptés au profil 102 d'implantation que l'on souhaite obtenir.

On notera ici que la nature de la résine, la dimension des motifs 120, la nature des ions implantés ainsi que les conditions d'implantation sont choisies de manière à ce qu'il n'y ait pas de consommation sensible de la résine du fait de l'opération d'implantation elle-même.

Typiquement, les motifs 120 sont des motifs bidimensionnels (2D) ou binaires, de formes sensiblement rectangulaires ou carrées obtenus très simplement par gravure complète d'une couche superficielle de résine 122. Ces motifs bidimensionnels (2D) ou binaires permettent cependant d'obtenir un profil 102 tridimensionnel (3D) de l'implantation en raison de l'inclinaison appliquée au faisceau d'ion et à l'effet de masquage produit par les motifs.

La figure 1b illustre le résultat d'une seconde implantation qui peut être optionnellement pratiquée en utilisant les mêmes motifs 120 formant écran au faisceau d'ions 130. Sur l'exemple illustré en figure 1b, l'angle d'incidence 132 est choisi pour être sensiblement symétrique, par rapport à une perpendiculaire au plan du substrat 101, à celui de la première implémentation.

Dans ce cas illustré en figure 1b, on obtient alors le profil 104 qui est lui-même le symétrique du profil 102 de la première implantation 102.

Le résultat de ces deux implantations est illustré par la figure 1c.

On notera qu'il n'y a toutefois aucune contrainte sur l'angle d'incidence de la seconde implantation qui peut être choisi librement avec pour seul critère de choix le profil final d'implantation souhaité dans le substrat 100.

En particulier cet angle d'incidence peut être égal à 90°. Dans ce cas la direction d'implantation est perpendiculaire au plan du substrat 101.

De préférence la direction d'implantation choisie lors de la deuxième implantation est différente de la direction d'implantation choisie lors de la première implantation.

On notera également qu'il est possible de n'avoir que l'une seulement des implantations qui est réalisée à travers un masque 121. En effet, la première ou la deuxième implantation peut être réalisée pleine plaque sans masque.

Selon un autre mode de réalisation non illustré le masque utilisé lors de la première implantation est différent de celui utilisé lors de la deuxième implantation.

A l'issue des première ou la deuxième implantations, certaines zones 106, 108 sont implantées à la fois lors de la première implantation et à la fois lors de la deuxième implantation.

Sur l'exemple non limitatif illustré, ces zones sont situées entre les motifs (zones 106) et ou sous les motifs (108).

Les conditions d'implantation sont réglées pour que seules les zones recevant une dose d'ions à la fois lors de la première implantation et à la fois lors de la deuxième implantation dépassent un seuil au-delà duquel le matériau du substrat est suffisamment modifié pour devenir nettement plus sensible à une gravure que le matériau non modifié ou modifié avec une dose inférieure au seuil.

Ainsi, lors d'une gravure subséquente, typiquement une gravure chimique, on peut graver les zones doublement implantées par rapport aux zones qui n'ont été implantées qu'une fois ou qui n'ont ont pas du tout été implantées.

La figure 1c illustre les zones qui n'ont été implantées qu'une fois (zones 107) et les zones qui n'ont ont pas du tout été implantées (zones 109).

Les zones 106, 108 ayant reçu une double implantation et seules susceptibles d'être gravées dans cet exemple, sont représentées sur la figure 1d.

On procède ensuite à une étape classique de retrait du masque 121 portant les motifs de résine 120.

Ensuite ou simultanément, on procède à une gravure humide de ces zones modifiées 106, 108 avec une dose supérieure au seuil. L'arrêt de la gravure se fait automatiquement à la frontière entre zones doublement implantées et zones implantées une seule fois ou non implantées. La fin de gravure peut également être contrôlée au temps si la sélectivité est suffisante entre d'une part les zones modifiées 106, 108 avec une dose supérieure au seuil et d'autre part les zones non modifiées 106, 108 avec une dose supérieure au seuil.

On obtient alors une structuration de surface du substrat 100 et un profil 105 comme illustré par la figure 1e.

Par exemple, on constate qu'entre deux tranches de silicium, l'une ayant subie une seule implantation et l'autre implantée à deux reprises dans des conditions identiques, une gravure humide à l'aide d'un bain d'hydroxyde de potassium (KOH) dilué à 20% et comprenant un surfactant (triton X-100) n'est effective que dans le cas de la double implantation. L'implantation, simple ou double, se faisant dans les mêmes conditions, c'est-à-dire : implantation d'ions argon (Ar) avec une énergie de 75 kilo électronvolts (keV) et une dose de $10^{15}$ atomes par $cm^2$, impactant une épaisseur de 120 nm de matériau depuis la surface, et une double implantation d'ions hydrogène (H) avec une dose de $10^{15}$ atomes par $cm^2$ et une énergie respectivement de 3 keV et 7 keV pour couvrir toute la profondeur à modifier (ie les 120nm modifiés par l'implantation d'Ar).

Ce mode de réalisation permet avantageusement d'obtenir une très bonne gravure.

Dans le cadre du développement de la présente invention il a été remarqué que l'on obtient une définition particulièrement précise des motifs lorsque l'on réalise :

- une implantation au cours de laquelle les ions modifient la structure physique du substrat cristallin pour le rendre amorphe. Cela nécessite l'implantation d'ions relativement lourds (au moins aussi lourds que le bore) tels que des ions argon (Ar), silicium ou bore;
- simultanément ou après l'amorphisation du substrat, une implantation au cours de laquelle les ions modifient la chimie du substrat. Cela nécessite l'implantation d'ions relativement légers tels que des ions hydrogène (H) et/ou oxygène. Ces ions légers se logent dans le substrat cristallin sans en modifier la structure cristallographique mais en créant des liaisons chimiques (notamment Si-H) qui vont facilement s'oxyder.

On notera que l'implantation réalisée pour amorphiser le substrat 100 peut être réalisée pleine plaque et sans masque sur toute la surface du substrat 100. Ensuite on vient définir les zones à graver en effectuant une modification chimique du substrat 100 à travers les motifs 120 d'un ou plusieurs masques 121.

A titre d'exemple, pour un substrat en silicium, le seuil au-delà duquel les zones implantées au moins lors de deux implantations peuvent être gravées sélectivement aux zones ayant reçu une dose inférieure au seuil est le suivant:

- Pour une gravure à base de KOH ou TMAH

  ○ une concentration en ions hydrogène de $10^{20}$ atomes par $cm^3$ et
  ○ à une concentration en ions argon de $10^{18}$ atomes par $cm^3$.

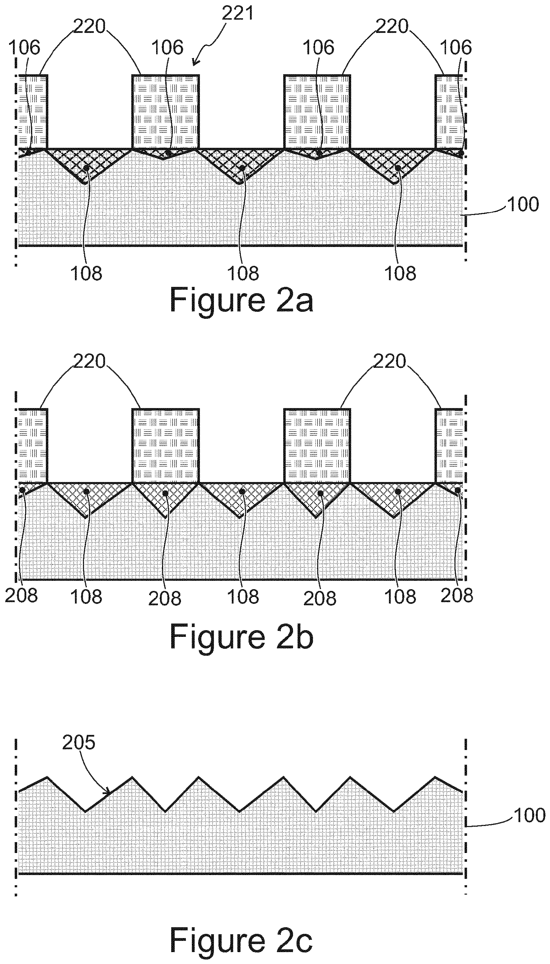

La **figure 2** composée des figures 2a à 2c illustre un deuxième mode de mise en oeuvre de l'invention. Dans ce cas, on effectue les étapes illustrées aux figures 1a à 1d.

Puis on retire le masque 121. A cette étape le substrat 100 n'est pas gravé.

On réalise ensuite des étapes supplémentaire décrites sur les figures 2a à 2c.

La première étape supplémentaire dans ce cas consiste donc à créer d'autres motifs 220 destinés à former un autre masque 221, cette fois alignés sur les zones implantées les moins profondes c'est-à-dire les zones 106, situées au droit des intervalles séparant les motifs précédents 120. Ceci est illustré par la figure 2a où l'on retrouve toutes les zones déjà implantées lors des étapes correspondant aux figures 1a à 1d, c'est-à-dire les zones 106 et 108. Les nouveaux motifs 220 sont réalisés de façon similaire à ce qui a été décrit pour la figure 1 en utilisant les techniques classiques de photolithographie.

Pour obtenir des motifs 220 alignés par rapport aux motifs 120 précédents on peut recourir à plusieurs techniques. On peut par exemple mettre en oeuvre la technique de lift off, c'est-à-dire par soulèvement des motifs après avoir déposé une couche destinée à former les motifs 220.

On peut également recourir aux équipements classiques de lithographie avancée qui permettent d'avoir des précisions d'alignements (overlay) inférieures à 10 nm.

A l'aide des nouveaux motifs 220, en répétant toutes les opérations déjà décrites pour les figures 1a à 1d on obtient le résultat illustré sur la figure 2b comprenant les zones implantées 108 et 208 qui sont alors sensiblement de mêmes forme, dimension et profondeur dans la mesure où les intervalles entre les motifs 120 ont été initialement choisis pour être identiques à la largeur de ces motifs.

Comme montré sur la figure 2c on obtient ainsi après gravure une structuration 205 beaucoup plus régulière de la surface du substrat 100.

Les implantations successives sont effectuées de manière à ce que seules les zones 108, 208 ayant reçu une dose d'ions lors des différentes implantations soient révélées lors de la gravure.

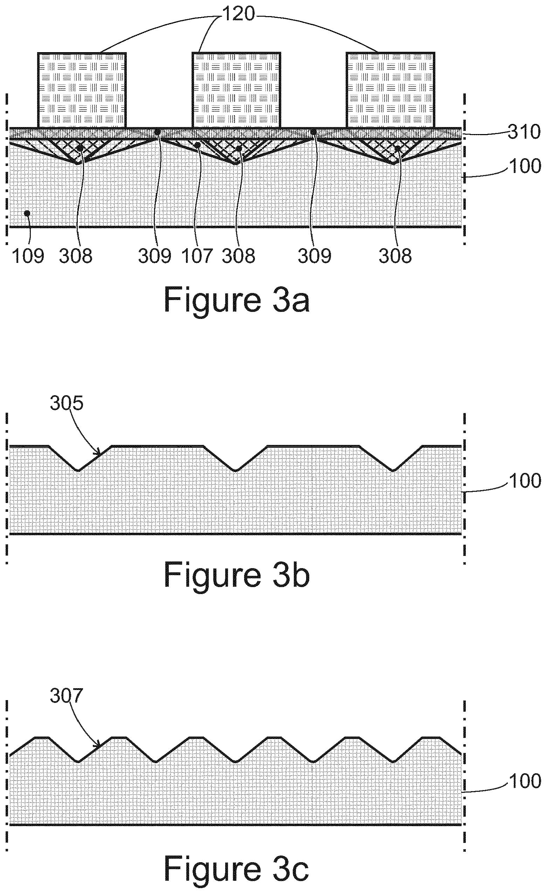

La **figure 3** composée des figures 3a à 3c illustre encore une autre façon d'obtenir une structuration de surface d'un substrat 100 selon l'invention.

La particularité dans ce cas consiste en ce que l'on forme sur le substrat, avant formation des motifs 120, une couche sacrificielle 310 dont l'épaisseur est au moins égale à la hauteur de certaines zones doublement implantées, ici les zones 106.

La couche sacrificielle 310 peut par exemple être réalisée à partir d'un matériau couramment utilisé en lithographie qui est connu sous l'acronyme de BARC de l'anglais « bottom anti-reflective coating » et qui constitue un revêtement anti-réflexion de fond pour certaines opérations de lithographie.

En adaptant l'épaisseur de la couche sacrificielle 310 à la hauteur maximale d'implantation dans le substrat des zones 106 on peut inclure celles-ci totalement dans la couche 310. Il n'y aura donc pas dans ce cas implantation dans le substrat 100 au niveau des motifs 309. Les zones implantées sous les motifs 120, les plus profondes, ici désignées par la référence 308, verront donc leur profondeur un peu limitée.

Par exemple cette couche présente une épaisseur de 20 à 50 nanomètres ($10^{-9}$ mètre). Elle est par exemple obtenue par dépôt. Dans cet exemple les motifs 120 présentent une épaisseur comprise entre 1nm et quelques nanomètres et les zones 308 présentent une profondeur également comprise entre 1nm et quelques nanomètres, la profondeur étant mesurée perpendiculairement à la surface du substrat 100 et depuis la surface de la couche sacrificielle 310 sur laquelle repose les motifs 120.

Après enlèvement des motifs 120 et de la couche sacrificielle 310 on peut procéder comme précédemment à une gravure humide sélective des zones implantées 308. On obtient alors le profil régulier 305 illustré par la figure 3b.

Cela permet de lisser le profil 305 obtenu sans avoir à effectuer une opération d'amincissement, tel qu'un polissage mécano-chimique pour éliminer les reliefs les moins profonds.

Si on répète avant gravure et enlèvement de la couche sacrificielle 310, les opérations d'implantation décrites dans les figures 1a à 1d et après avoir formés de nouveaux motifs 220 comme expliqué en figure 2, on obtient alors, après gravure, une structuration de surface 307 qui est beaucoup plus dense. Ceci est illustré par la figure 3c.

Les figures suivantes proposent des exemples qui permettront de déterminer les conditions de mise en oeuvre du procédé de l'invention destiné à produire une structuration de surface d'un substrat telle qu'illustrée par les figures 1e, 2c, 3b et 3c.

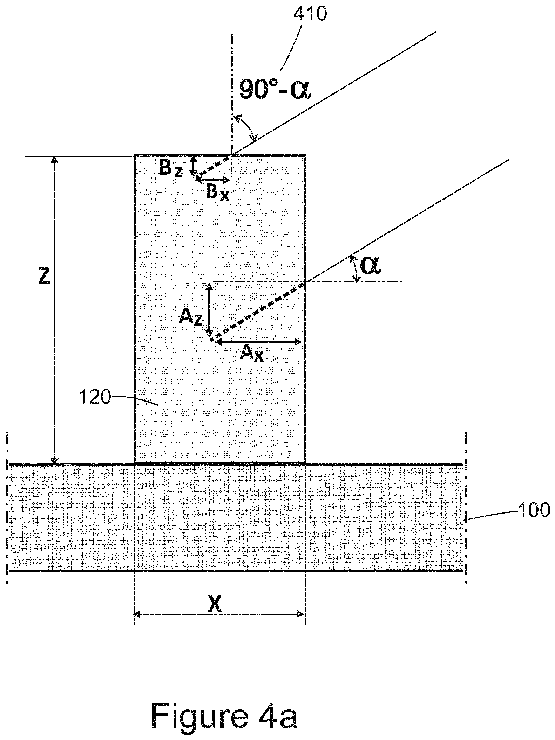

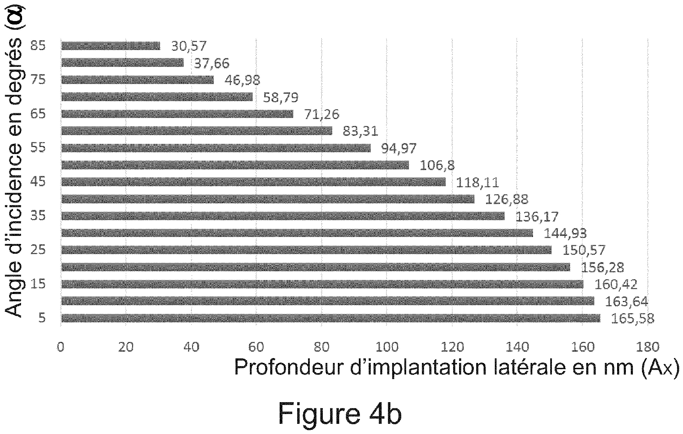

La **figure 4,** composée des figures 4a et 4b, étudie la pénétration des ions dans les motifs en résine du masque. La figure 4a définit les paramètres suivants :

α : est l'angle d'incidence du faisceau sur les flancs des motifs 120 de masque. Cette direction d'implantation est aussi désignée par les références 112 et 132 dans la description qui précède de l'invention. L'inclinaison d'implantation par rapport la perpendiculaire au plan du substrat 100 à structurer est, comme indiqué 410, égale à : 90°- α ;

$A_x$: est la profondeur modifiée dans la résine par implantation selon une direction parallèle au plan du substrat (X) ;

$B_z$: est la profondeur modifiée dans la résine par implantation selon une direction perpendiculaire au plan du substrat (Z) ;

X : est largeur du motif ;

Z : est la hauteur du motif.

Comme déjà indiqué dans la description qui précède on considère que la consommation de résine du masque n'est pas sensiblement affectée par l'opération d'implantation elle-même.

La figure 4b montre, la profondeur d'implantation latérale ($A_x$) au plan du substrat 100 dans la résine des motifs 120 du masque en fonction de l'angle d'incidence (a). Cette figure montre des résultats de simulations qui ont été réalisées pour une résine de densité égale à 1 gramme par $cm^{-3}$ ayant subie une implantation d'ions argon (Ar) avec une énergie de 100 keV et une densité d'implantation de $10^{16}$ atomes par $cm^2$. L'étude de la pénétration des ions sur les flancs des motifs permet d'anticiper les modifications de surface du substrat 100 situé sous le masque.

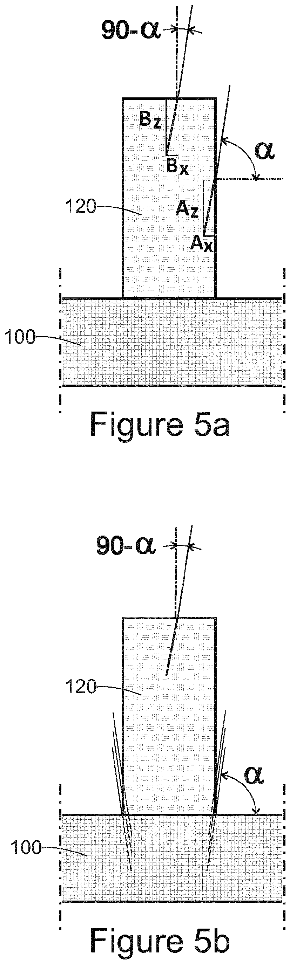

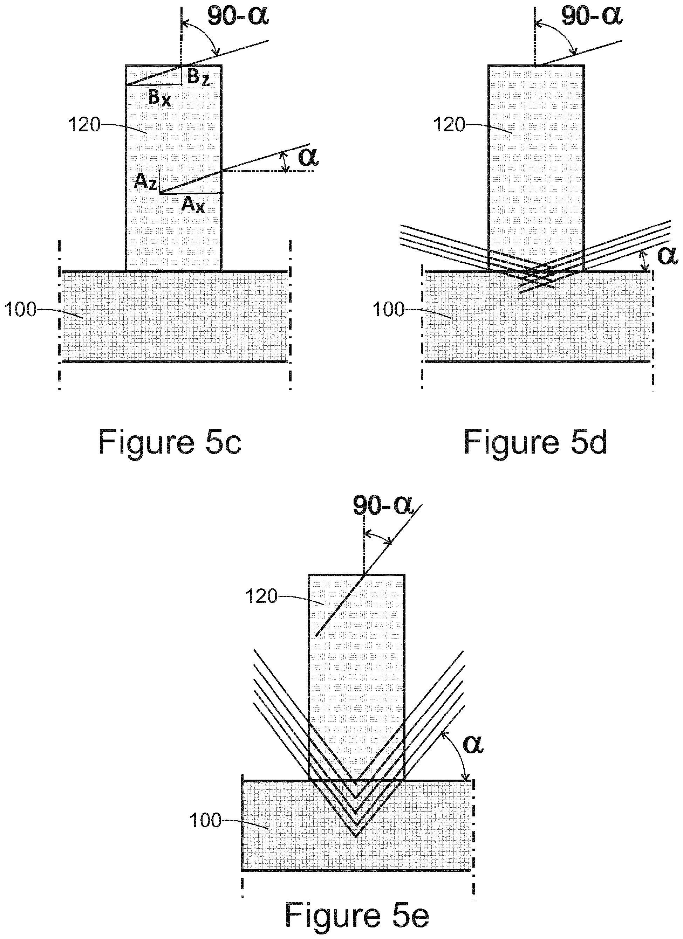

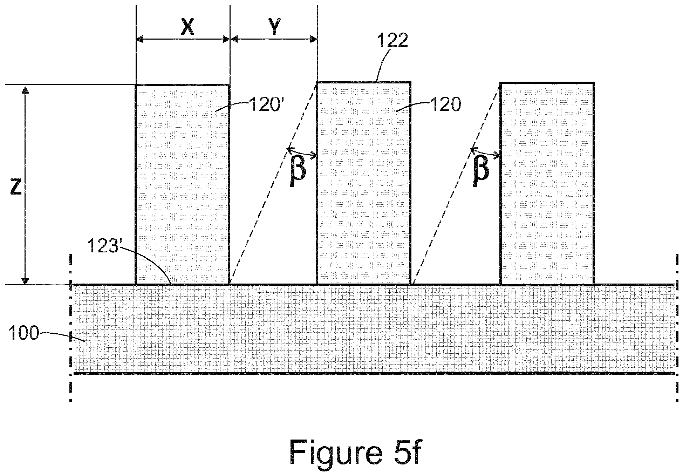

La **figure 5,** composée des figures 5a à 5f, illustre et discute différentes options de réglage de l'angle d'incidence du faisceau d'ions sur le résultat de l'implantation d'espèces pour la structuration de surface d'un substrat.

Les figures 5a et 5b traitent du cas d'un angle d'incidence α supérieur à 45°. Dans ce cas, le faisceau pénètre les flancs des motifs 120 sous un angle élevé ce qui n'induit qu'une légère modification latérale de la résine alors qu'une modification plus importante peut être observée au sommet de ceux-ci.

La figure 5b illustre la pénétration du faisceau dans le substrat 100 sous-jacent au motif 120. En pratique on remarque qu'on obtient effectivement une implantation sous le masque de résine due en grande partie à l'inclinaison du faisceau d'ions.

Les figures 5c et 5d illustrent le cas où l'angle d'incidence α est inférieur à 45°. La figure 5c montre la pénétration du faisceau d'ions dans le motif 120 en résine et la figure 5d la pénétration de celui-ci dans le matériau du substrat 100 sous-jacent. Dans ce cas la pénétration latérale des ions est importante, il faut néanmoins trouver le bon compromis pour atteindre la profondeur verticale souhaitée.

La figure 5e illustre le cas où l'angle d'incidence α est égal à 45°. Ce dernier cas permet à la fois d'implanter des ions sous les motifs 120 du masque et également d'atteindre une profondeur optimale dans le matériau du substrat 100 sous-jacent.

La figure 5f montre comment on peut déterminer la condition pour laquelle la zone non protégée, c'est-à-dire la zone inter-motifs de largeur Y, n'est pas implantée. Dans ce cas l'angle β doit être supérieur ou égal à :

$$\arctan\left(\frac{Y}{Z}\right).$$

L'angle β est l'angle formé par l'intersection entre le flanc d'un motif 120 et la droite passant par d'une part le sommet 122 de ce motif 120 et d'autre part la base 123' du motif 120' adjacent au motif 120.

Les courbes des figures 4b et 4c combinées avec la condition ci-dessus et aux discussions ci-dessus illustrées par les figures 4a à 5e permettent de définir les angles à utiliser pour implanter sous le masque ainsi que les texturisations souhaitées.

Au vu de la description qui précède, il apparaît clairement que l'invention permet d'obtenir de manière reproductible et peu couteuse des motifs ou une texturation présentant un profil possiblement complexe.

L'invention n'est pas limitée aux modes de réalisations précédemment décrits et s'étend à tous les modes de réalisation couverts par les revendications.

## Revendications

1. Procédé de formation de reliefs à la surface (101) d'un substrat (100), **caractérisé en ce qu'**il comprend au moins les étapes suivantes:

   - au moins une première implantation d'ions dans le substrat (100) selon une première direction (112) ;
   - au moins une deuxième implantation d'ions dans le substrat (100) selon une deuxième direction (132) différente de la première direction (112);
   - au moins l'une des première et deuxième implantations est réalisée à travers au moins un masque (121, 221) présentant au moins un motif (120, 220);
   - une gravure de zones (106, 108, 208) du substrat (100) ayant reçu par implantation une dose supérieure ou égale à un seuil, sélectivement aux zones (107, 109) du substrat (100) n'ayant pas reçu par implantation une dose supérieure audit seuil ;

   les paramètres des première et deuxième implantations, en particulier leurs directions (112, 132) respectives, étant réglées de manière à ce que uniquement des zones (106, 108, 208) du substrat (100) ayant été implantées à la fois lors de la première implantation et lors de la deuxième implantation reçoivent une dose supérieure ou égale audit seuil.

2. Procédé selon la revendication précédente, dans lequel les première et deuxième implantations sont chacune réalisées à travers au moins un masque (121, 221).

3. Procédé selon la revendication précédente, dans lequel les première et deuxième implantations sont réalisées à travers un même masque (121, 221), le procédé comprenant au moins une implantation additionnelle réalisée à travers un masque (121, 221) différent de celui utilisé lors des première et deuxième implantations.

4. Procédé selon la revendication 2 dans lequel l'au moins un motif (120, 220) du masque (121, 221) utilisé lors de la première implantation est différent de l'au moins un motif (120, 220) du masque (121, 221) utilisé lors de la deuxième implantation.

5. Procédé selon la revendication 1, dans lequel au moins l'une des première et deuxième implantations est réalisée pleine plaque et sans masque (121, 221).

6. Procédé selon l'une quelconque des revendications précédentes dans lequel on dispose une couche sacrificielle (310) au-dessus du substrat (100) et dans lequel au moins l'une parmi la première et la deuxième implantations est réalisée à travers ladite couche sacrificielle (310).

7. Procédé selon la revendication précédente, dans lequel on retire toute la couche sacrificielle (310) après la deuxième implantation.

8. Procédé selon l'une quelconque des deux revendications précédentes dans lequel l'épaisseur de la couche sacrificielle (310) est choisie et au moins l'une parmi la première et la deuxième implantations sont réalisées de manière à ce que des premières zones (309) situées sous le masque (121, 221) soient implantées à la fois lors de la première implantation et lors de la deuxième implantation, reçoivent une dose supérieure ou égale audit seuil et s'étendent uniquement dans la couche sacrificielle (310).

9. Procédé selon l'une quelconque des trois revendications précédentes dans lequel l'épaisseur de la couche sacrificielle (310) ainsi que au moins l'une parmi la première et la deuxième implantations sont réalisées de manière à ce que des deuxièmes zones (308) situées sous le masque (121, 221) soient implantées à la fois lors de la première implantation et lors de la deuxième implantation en recevant une dose supérieure ou égale audit seuil, lesdites deuxièmes régions (308) s'étendant dans la couche sacrificielle (310) et dans le substrat (100).

10. Procédé selon l'une quelconque des revendications précédentes dans lequel le substrat (100) est cristallin et dans lequel au moins l'une parmi la première et la deuxième implantations est effectuée de manière à rendre les zones implantées amorphes.

11. Procédé selon la revendication précédente dans lequel ladite implantation prise parmi la première et la deuxième implantations et effectuée de manière à rendre les zones implantées amorphes comprend l'implantation des ions plus lourds que l'hydrogène (H), tels que des ions bore, argon (Ar) ou silicium avec une énergie suffisante pour rendre les zones implantées amorphes.

12. Procédé selon l'une quelconque des revendications précédentes dans lequel au moins l'une parmi la première et la deuxième implantations est effectuée de manière à modifier chimiquement le substrat (100) et de préférence dans lequel ladite implantation prise parmi la première et la deuxième implantations et effectuée de manière à modifier chimiquement le substrat (100) comprend l'implantation d'ions hydrogène (H) et/ou d'oxygène pour modifier chimiquement le substrat (100).

13. Procédé selon l'une quelconque des revendications précédentes dans lequel au moins certaines des zones (108) recevant une dose supérieure ou égale audit seuil sont situées sous un motif (120, 221) du masque (121, 221) lors d'au moins l'une des première et deuxième implantations.

14. Procédé selon l'une quelconque des revendications précédentes :

    - - dans lequel au moins l'une des première et deuxième directions (112, 132) d'implantation est perpendiculaire à un plan principal dans lequel s'étend le substrat (100),
    ou
    - - dans lequel les directions (112, 132) d'implantation de la première implantation et de la deuxième implantation sont inclinées par rapport à une direction perpendiculaire à un plan principal dans lequel s'étend le substrat (100).

15. Procédé selon l'une quelconque des revendications précédentes,

    - dans lequel le substrat (100) est fait d'un matériau comprenant au moins l'un des matériaux suivants : silicium (Si), en silicium-germanium (SiGe), saphir, SiC, GaN ou quartz,
    ou
    - dans lequel le substrat (100) est poreux.

**Patentansprüche**

1. Verfahren zum Bilden von Erhebungen an der Oberfläche (101) eines Substrats (100), **dadurch ge-**

**kennzeichnet, dass** es mindestens die folgenden Schritte umfasst:

    - mindestens eine erste Implantation von Ionen in das Substrat (100) entlang einer ersten Richtung (112);
    - mindestens eine zweite Implantation von Ionen in das Substrat (100) entlang einer zweiten Richtung (132), die sich von der ersten Richtung (112) unterscheidet;
    - mindestens eine aus der ersten und zweiten Implantation wird durch mindestens eine Maske (121, 221) hindurch ausgeführt, die mindestens ein Muster (120, 220) aufweist;
    - ein Ätzen von Zonen (106, 108, 208) des Substrats (100), die durch Implantation eine Dosis empfangen haben, die größer oder gleich einer Schwelle ist, selektiv zu den Zonen (107, 109) des Substrats (100), die durch Implantation keine Dosis empfangen haben, die größer als die Schwelle ist;

    wobei die Parameter der ersten und zweiten Implantation, insbesondere ihre jeweiligen Richtungen (112, 132), so eingestellt werden, dass nur Zonen (106, 108, 208) des Substrats (100), die zugleich bei der ersten Implantation und bei der zweiten Implantation implantiert wurden, eine Dosis empfangen, die größer oder gleich der Schwelle ist.

2. Verfahren nach dem vorstehenden Anspruch, wobei die erste und zweite Implantation jede durch mindestens eine Maske (121, 221) hindurch ausgeführt werden.

3. Verfahren nach dem vorstehenden Anspruch, wobei die erste und zweite Implantation durch ein und dieselbe Maske (121, 221) hindurch ausgeführt werden, wobei das Verfahren mindestens eine zusätzliche Implantation umfasst, die durch eine Maske (121, 221) hindurch ausgeführt wird, welche sich von derjenigen, die bei der ersten und zweiten Implantation verwendet wird, unterscheidet.

4. Verfahren nach Anspruch 2, wobei sich das mindestens eine Muster (120, 220) der Maske (121, 221), die bei der ersten Implantation verwendet wird, von dem mindestens einen Muster (120, 220) der Maske (121, 221), die bei der zweiten Implantation verwendet wird, unterscheidet.

5. Verfahren nach Anspruch 1, wobei mindestens eine aus der ersten und zweiten Implantation vollflächig und ohne Maske (121, 221) ausgeführt wird.

6. Verfahren nach einem der vorstehenden Ansprüche, wobei über eine Opferschicht (310) über dem Substrat (100) verfügt wird, und wobei mindestens eine aus der ersten und der zweiten Implantation durch die Opferschicht (310) hindurch ausgeführt wird.

7. Verfahren nach dem vorstehenden Anspruch, wobei nach der zweiten Implantation die gesamte Opferschicht (310) entfernt wird.

8. Verfahren nach einem der zwei vorstehenden Ansprüche, wobei die Dicke der Opferschicht (310) so ausgewählt und mindestens eine aus der ersten und der zweiten Implantation so ausgeführt wird, dass erste Zonen (309), die unter der Maske (121, 221) liegen, zugleich bei der ersten Implantation und bei der zweiten Implantation implantiert werden, eine Dosis empfangen, die größer oder gleich der Schwelle ist, und sich nur in der Opferschicht (310) erstrecken.

9. Verfahren nach einem der drei vorstehenden Ansprüche, wobei die Dicke der Opferschicht (310) sowie mindestens eine aus der ersten und der zweiten Implantation so ausgeführt werden, dass zweite Zonen (308), die unter der Maske (121, 221) liegen, zugleich bei der ersten Implantation und bei der zweiten Implantation implantiert werden unter Empfangen einer Dosis, die größer oder gleich der Schwelle ist, wobei sich die zweiten Regionen (308) in der Opferschicht (310) und im Substrat (100) erstrecken.

10. Verfahren nach einem der vorstehenden Ansprüche, wobei das Substrat (100) kristallin ist, und wobei mindestens eine aus der ersten und der zweiten Implantation so vorgenommen wird, dass sie die implantierten Zonen amorph macht.

11. Verfahren nach dem vorstehenden Anspruch, wobei die Implantation, die aus der ersten und der zweiten Implantation gewählt und so vorgenommen wird, dass sie die implantierten Zonen amorph macht, die Implantation der Ionen umfasst, die schwerer sind als Wasserstoff (H), wie etwa von Bor-, Argon- (Ar) oder Siliziumionen, mit einer Energie, die ausreichend ist, um die implantierten Zonen amorph zu machen.

12. Verfahren nach einem der vorstehenden Ansprüche, wobei mindestens eine aus der ersten und der zweiten Implantation so vorgenommen wird, dass sie das Substrat (100) chemisch modifiziert, und wobei vorzugsweise die Implantation, die aus der ersten und der zweiten Implantation gewählt und so vorgenommen wird, dass sie das Substrat (100) chemisch modifiziert, die Implantation von Wasserstoff- (H) und/oder von Sauerstoffionen umfasst, um das Substrat (100) chemisch zu modifizieren.

13. Verfahren nach einem der vorstehenden Ansprüche, wobei mindestens gewisse der Zonen (108), die eine Dosis empfangen, welche größer oder gleich der Schwelle ist, bei mindestens einer aus der ersten und zweiten Implantation unter einem Muster (120, 221) der Maske (121, 221) liegen.

14. Verfahren nach einem der vorstehenden Ansprüche:

    - wobei mindestens eine aus der ersten und zweiten Implantationsrichtung (112, 132) zu einer Hauptebene, in der sich das Substrat (100) erstreckt, senkrecht ist,
    - wobei die Implantationsrichtungen (112, 132) der ersten Implantation und der zweiten Implantation in Bezug auf eine Richtung, die zu einer Hauptebene, in der sich das Substrat (100) erstreckt, senkrecht ist, geneigt sind.

15. Verfahren nach einem der vorstehenden Ansprüche,

    - wobei das Substrat (100) aus einem Material gefertigt ist, das mindestens eines der folgenden Materialien umfasst: Silizium (Si), aus Silizium-Germanium (SiGe), Saphir, SiC, GaN oder Quarz,
oder
    - wobei das Substrat (100) porös ist.

**Claims**

1. Method for forming reliefs on the surface (101) of a substrate (100), **characterised in that** it comprises at least the following steps:

    - at least one first implantation of ions in the substrate (100) along a first direction (112);
    - at least one second implantation of ions in the substrate (100) along a second direction (132), different from the first direction (112);
    - at least one of the first and second implantations is done through at least one mask (121, 221) having at least one pattern (120, 220);
    - an engraving of zones (106, 108, 208) of the substrate (100) having received by implantation, a dose greater than or equal to a threshold, selectively to the zones (107, 109) of the substrate (100) not having received by implantation, a dose greater than said threshold;

the parameters of the first and second implantations, in particular the respective directions (112, 132) thereof, being adjust such that only the zones (106, 108, 208) of the substrate (100) having been implanted both during the first implantation and during the second implantation receive a dose greater than or equal to said threshold.

2. Method according to the preceding claim, wherein the first and second implantations are each done through at least one mask (121, 221).

3. Method according to the preceding claim, wherein the first and second implantations are done through one same mask (121, 221), the method comprising at least one additional implantation done through a mask (121, 221), different from that used during the first and second implantations.

4. Method according to claim 2, wherein the at least one pattern (120, 220) of the mask (121, 221) used during the first implantation is different from the at least one pattern (120, 220) of the mask (121, 221) used during the second implantation.

5. Method according to claim 1, wherein at least one of the first and second implantations is done solid plate and without mask (121, 221).

6. Method according to any one of the preceding claims, wherein a sacrificial layer (310) is arranged above the substrate (100) and wherein at least one from among the first and second implantations is done through said sacrificial layer (310).

7. Method according to the preceding claim, wherein the whole sacrificial layer (310) is removed after the second implantation.

8. Method according to any one of the two preceding claims, wherein the thickness of the sacrificial layer (310) is selected and at least one from among the first and the second implantations are made such that the first zones (309) situated under the mask (121, 221) are implanted both during the first implantation and during the second implantation, receive a dose greater than or equal to said threshold and extend only into the sacrificial layer (310).

9. Method according to any one of the three preceding claims, wherein the thickness of the sacrificial layer (310) as well as at least one from among the first and the second implantations are done such that the two zones (308) situated under the mask (121, 221) are implanted both during the first implantation and during the second implantation by receiving a dose greater than or equal to said threshold, said second regions (308) extending into the sacrificial layer (310) and into the substrate (100).

10. Method according to any one of the preceding claims, wherein the substrate (100) is crystalline and wherein at least one from among the first and the second implantations is made so as to make amorphous implanted zones.

11. Method according to the preceding claim, where said implantation taken from among the first and the second implantations and done so as to make amorphous implanted zones comprises the implantation of ions, heavier than hydrogen (H), such as boron ions, argon (Ar) ions or silicon ions, with an energy sufficient to make amorphous implanted zones.

12. Method according to any one of the preceding claims, wherein at least one from among the first and the second implantations is done so as to chemically modify the substrate (100) and preferably wherein said implantation taken from among the first and the second implantations and done so as to chemically modify the substrate (100) comprises the implantation of hydrogen (H) ions and/or oxygen ions to chemically modify the substrate (100).

13. Method according to any one of the preceding claims, wherein at least some of the zones (108) receiving a dose greater than or equal to said threshold are situated under a pattern (120, 221) of the mask (121, 221) during at least one of the first and second implantations.

14. Method according to any one of the preceding claims:

    - wherein at least one of the first and second directions (112, 132) of implantation is perpendicular to a main plane wherein the substrate (100) extends,
    - wherein the directions (112, 132) of implantation of the first implantation and of the second implantation are tilted with respect to a direction perpendicular to a main plane wherein the substrate (100) extends.

15. Method according to any one of the preceding claims,

    - wherein the substrate (100) is made from a material comprising at least one of the following materials: silicon (Si), silicon-germanium (SiGe), sapphire, SiC, GaN or quartz, or
    - wherein the substrate (100) is porous.

110

122

121

112

101

120

102

102

100

## Figure 1a

130

132

120

101

120

104

120

104

## Figure 1b

106    106    106    106

108    107    108    107    108    109

## Figure 1c

120  120  120

106  106  106  106

100

108  108  108

## Figure 1d

105

100

## Figure 1e

221

220

106            106            106            220            106

100

108            108            108

Figure 2a

220                              220

208   108   208   108   208   108   208

Figure 2b

205

100

Figure 2c

120

310

100

109 308 309 107 308 309 308

## Figure 3a

305

100

## Figure 3b

307

100

## Figure 3c

Figure 4a

Figure 4b

Figure 5a

Figure 5b

Figure 5c

Figure 5d

Figure 5e

Figure 5f

## RÉFÉRENCES CITÉES DANS LA DESCRIPTION

### Documents brevets cités dans la description

- US 2015214099 A1